# EUROPÄISCHE PATENTSCHRIFT

(11) **EP 2 179 426 B1**
(45) Veröffentlichungstag und Bekanntmachung des Hinweises auf die Patenterteilung: **02.05.2018**
(21) Anmeldenummer: 08845846.8
(22) Anmeldetag: 16.10.2008
(51) Int. Cl.: H01C 1/14, H01G 4/228, H01G 9/20, C23C 28/00, H01L 21/768, C23C 24/04, H01L 31/0224, H05K 3/14, H01L 31/0296, H01L 31/0368, H01L 31/0392, H05K 1/03, H05K 3/40, H05K 3/46, H01L 31/032, H01L 31/0376

(54) **MEHRSCHICHTSYSTEM MIT KONTAKTELEMENTEN UND VERFAHREN ZUM ERSTELLEN EINES KONTAKTELEMENTS FÜR EIN MEHRSCHICHTSYSTEM**
MULTILAYER SYSTEM COMPRISING CONTACT ELEMENTS, AND METHOD FOR THE PRODUCTION OF A CONTACT ELEMENT FOR A MULTILAYER SYSTEM
SYSTÈME MULTICOUCHE COMPRENANT DES ÉLÉMENTS DE CONTACT ET PROCÉDÉ DE PRODUCTION D'UN ÉLÉMENT DE CONTACT POUR UN SYSTÈME MULTICOUCHE

(30) Priorität: 02.11.2007 DE 102007052414; 11.06.2008 DE 102008027770
(43) Veröffentlichungstag der Anmeldung: 28.04.2010
(73) Patentinhaber: INTERPANE Entwicklungs- und Beratungsgesellschaft mbH & Co. KG, 37698 Lauenförde (DE); GfE Fremat GmbH, 09599 Freiberg (DE)
(72) Erfinder: BEREK, Harry, 09600 Oberschöna (DE); PAUL, Alexander, 09599 Freiberg (DE); SCHMIDT, Steffen, 09599 Freiberg (DE); HERLITZE, Lothar, 37691 Derenthal (DE); WEIS, Hansjörg, 37671 Höxter (DE); HÄUSER, Karl, 37688 Beverungen (DE)
(74) Vertreter: Beder, Jens
(86) Internationale Anmeldenummer: PCT/EP2008/008778
(87) Internationale Veröffentlichungsnummer: WO 2009/056235

(56) Entgegenhaltungen:
- EP-A- 1 382 707
- EP-A- 1 517 597
- DE-A1- 10 045 783
- DE-A1- 10 320 740
- DE-B3-102004 059 716
- JP-A- 9 027 547
- US-A- 5 888 902
- US-A- 6 162 649
- LIMA R S ET AL: "Microstructural characteristics of cold-sprayed nanostructured WC-Co coatings" THIN SOLID FILMS, ELSEVIER-SEQUOIA S.A. LAUSANNE, CH, Bd. 416, Nr. 1-2, 2. September 2002 (2002-09-02), Seiten 129-135, XP004389743 ISSN: 0040-6090

## Beschreibung

Die vorliegende Erfindung betrifft ein Mehrschichtsystem mit einem Kontaktelement sowie ein Verfahren zum Erstellen eines Kontaktelements für ein Mehrschichtsystem. Die vorliegende Erfindung betrifft insbesondere ein Kontaktelement sowie ein Verfahren zum Erstellen eines Kontaktelements, welches auch tiefer liegende Schichten kontaktieren kann.

Ein Verfahren zum Herstellen einer elektrisch leitenden Widerstandsschicht ist in der DE 101 62 276 A1 offenbart. Hierfür wird zunächst mittels thermischem Spritzen auf einen nichtleitenden Untergrund ein elektrisch leitendes Material flächig aufgebracht. Die hieraus entstandene Materialschicht weist noch keine gewünschte Form auf und wird daher im Folgenden bereichsweise derart entfernt, dass eine elektrisch leitende Widerstandsschicht entsteht, welche im Wesentlichen die gewünschte Form hat. Hierbei können insbesondere Leiterbahnen erzeugt werden.

Nachteilig bei dem genannten Verfahren ist jedoch, dass Leiterbahnen und elektrische Kontakte lediglich auf der obersten Schicht, das heißt auf der Oberfläche erzeugt werden können.

Ein Verfahren zum Erzeugen einer Leiterbahn auf einem Trägerbauteil, wobei die Leiterbahn auch in tiefer liegenden Schichten vorhanden ist, ist in Dokument WO 03/070524 A1 offenbart. Bei diesem Verfahren wird die Leiterbahn auf einem Trägerbauteil durch ein strahlgebundenes thermisch-kinetisches Auftragsverfahren direkt aufgetragen. Anschließend werden die weiteren Schichten über der Leiterbahn aufgetragen.

Nachteilig bei dem genannten Verfahren ist, dass das Aufbringen der Leiterbahn sehr aufwendig ist und nur während der Erstellung des Trägerbauteils möglich ist, und nicht ermöglicht, eine Leiterbahn auch nach Fertigstellung des Trägerbauteils noch aufzubringen. Des Weiteren ist die elektrische Kontaktierung der tiefliegenden Leiterbahn aufwendig.

Aus der US 5,888,902 A ist ein Mehrschichtsystem bekannt, bei dem ein Kontaktelement zumindest eine obere Schicht durchdringt, um mit einer unteren Schicht in Kontakt zu sein. Das Kontaktelement kann dabei aus einem leitfähigen Material, beispielsweise Wolfram oder Aluminium bestehen. Die Vertiefung, die zur Kontaktierung der darunterliegenden Schicht in der oberen Schicht erzeugt wird, wird durch Ätzen in die obere Schicht eingebracht.

Die vorliegende Erfindung hat daher die Aufgabe, ein Kontaktelement für ein Mehrschichtsystem bereitzustellen sowie ein Verfahren zum Erstellen eines Kontaktelements für ein Mehrschichtsystem zu schaffen, welches in jedem Prozessstadium einfach zu realisieren ist und einen einfachen Anschluss des Kontaktelements ermöglicht.

Die Aufgabe wird durch ein Schichtsystem mit einem Kontaktelement gemäß Anspruch 1 sowie durch ein Verfahren zum Erstellen eines Kontaktelements für ein Schichtsystem gemäß Anspruch 12 gelöst. Vorteilhafte Weiterbildungen der Erfindung sind in den Unteransprüchen angegeben.

Die vorliegende Erfindung betrifft ein Schichtsystem mit Kontaktelement umfassend ein Substrat, ein auf dem Substrat angeordnetes Mehrschichtsystem mit zumindest einer oberen und einer unteren Schicht, und ein Kontaktelement, welches die zumindest eine obere Schicht durchdringt und die untere Schicht kontaktiert. Dabei ist das Kontaktelement mittels Kaltgasspritzen aufgebracht.

Vorzugsweise ist das Kontaktelement aus elektrisch leitfähigem Material, vorzugsweise aus Aluminium, Kupfer, Silber, Zinn, Zink, Nickel, Titan oder einer Legierung der genannten Materialien. Das Substrat kann Glas sein.

Vorzugsweise ist die untere Schicht eine elektrisch leitende Schicht.

In einer Ausführungsform ist die untere Schicht insbesondere eine Aluminiumschicht, eine NiV-Schicht, eine Molybdänschicht, eine Kupferschicht, eine EdelmetallSchicht oder eine Kombination aus den genannten Materialen, besonders bevorzugt eine Silberschicht.

In einer weiteren Ausführungsform besteht die untere Schicht (2; 3) aus einem Material aus der Gruppe der transparent leitfähigen Oxide, sog. TCOs, bevorzugt aus SnO2: F, Indiumzinnoxid ITO, Indiumzinkoxid IZO, ZnOrAI, ZnOiSb oder ZnO: B.

Vorzugweise bedeckt das Kontaktelement das Mehrschichtsystem teilweise.

Besonders bevorzugt ist das Kontaktelement als Streifen auf dem Mehrschichtsystem ausgebildet.

In einer bevorzugten Ausführungsform sind zwei Kontaktelemente auf dem Mehrschichtsystem ausgebildet.

In einer bevorzugten Ausführungsform ist das Mehrschichtsystem eine photovoltaische Zelle, vorzugsweise eine photovoltaische Dünnschichtzelle.

In dieser bevorzugten Ausführungsform umfasst die photovoltaische Zelle zumindest zwei Kontaktschichten und eine zwischen den Kontaktschichten angeordnete solaraktive Schicht und das Kontaktelement durchdringt zumindest die solaraktive Schicht und kontaktiert zumindest eine der Kontaktschichten.

Die vorliegende Erfindung betrifft des Weiteren ein Verfahren zum Erstellen eines Kontaktelements für ein Schichtsystem umfassend die Schritte
- Bereitstellen eines Substrats mit einem auf dem Substrat angeordneten Mehrschichtsystem mit zumindest einer oberen und einer unteren Schicht und
- Aufbringen eines Kontaktelements mittels Kaltgasspritzen derart, dass das Kontaktelement die zumindest eine obere Schicht durchdringt und die untere Schicht kontaktiert.

In einer bevorzugten Ausführungsform umfasst das Verfahren das Vorsehen einer Vorrichtung zum Kaltgasspritzen umfassend eine Trägergaskammer, eine Partikelkammer, einen Pulverförderer zum Verbringen der Partikel aus der Partikelkammer in eine Mischkammer und eine Düse zum Aufbringen des Partikel-Gas-Gemisches aus der Mischkammer auf das Mehrschichtsystem.

Vorzugsweise umfasst das Verfahren das Vorsehen von Stickstoff N₂ als Trägergas.

Vorzugsweise umfasst das Verfahren das Vorsehen von Aluminiumpartikeln als Pulver.

Vorzugsweise umfasst das Verfahren das Vorsehen einer Trägergastemperatur von 100°C bis 500°C, vorzugsweise von 400°C.

Vorzugsweise umfasst das Verfahren das Vorsehen eines Trägergasdrucks von 5 bar bis 30 bar, vorzugsweise von 5 bar bis 25 bar, besonders bevorzugt von 15 bar.

Vorzugsweise umfasst das Verfahren das Vorsehen einer Relativgeschwindigkeit der Düse der Vorrichtung zum Kaltgasspritzen gegenüber dem Substrat mit dem Mehrschichtsystem von 10 m/min.

Vorzugsweise umfasst das Verfahren das Vorsehen einer Pulverförderrate der Vorrichtung zum Kaltgasspritzen (13) von 5 bis 70 g/min, bevorzugt von 10 bis 20 g/min.

Vorzugsweise umfasst das Verfahren das Vorsehen eines Abstands zwischen der Düse der Vorrichtung zum Kaltgasspritzen und dem Mehrschichtsystem von 20mm bis 30mm, besonders bevorzugt von 25 mm.

Nachfolgend werden besonders bevorzugte Ausführungsbeispiele der Erfindung unter Bezugnahme auf die beiliegenden Zeichnungen im Detail erläutert. In den Zeichnungen zeigen:
Fig. 1 das Prinzip des Aufbaus eines Mehrschichtsystems,
Fig. 2a - 2c 3 Beispiele für ein Mehrschichtsystem in unterschiedlichen Anwendungen,
Fig. 3 ein Mehrschichtsystem mit Kontaktelement gem. der vorliegenden Erfindung sowie eine Vorrichtung zum Erstellen eines solchen Mehrschichtsystems mit Kontaktelement gem. der vorliegenden Erfindung,
Fig. 4 zeigt ein Diagramm mit unterschiedlichen Widerstandswerten eines Kontaktelements gem. der vorliegenden Erfindung,
Fig. 5 zeigt ein Flussdiagramm mit den Verfahrensschritten des Herstellungsverfahrens gem. der vorliegenden Erfindung,
Fig. 6 zeigt ein Mehrschichtsystem mit Kontaktelement gem. der vorliegenden Erfindung und
Fig. 7 zeigt eine photovoltaische Zelle mit einem Kontaktelement gem. der vorliegenden Erfindung.

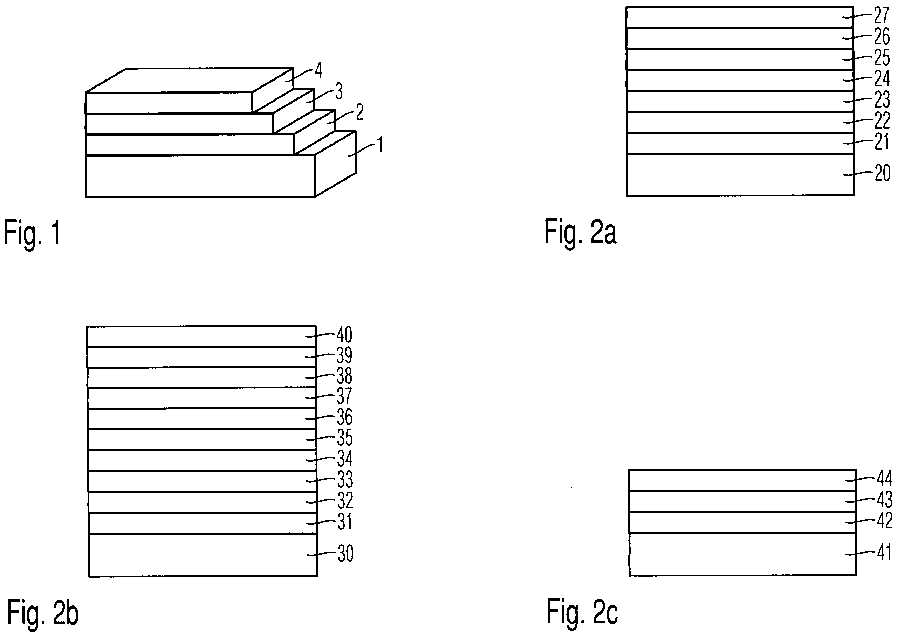

Fig. 1 zeigt den grundsätzlichen Schichtaufbau eines Schichtsystems gemäß der vorliegenden Erfindung. Auf einem Substrat 1 wird ein Mehrschichtsystem 14 aufgetragen, wobei das Mehrschichtsystem 14 eine Basisschicht 2, eine Zwischenschicht 3, und eine Deckschicht 4 umfasst. Hierfür wird zunächst eine Basisschicht 2 aufgetragen. Darüber wird eine Zwischenschicht 3 und anschließend eine Deckschicht 4 aufgetragen. Gemäß der Terminologie der vorliegenden Erfindung kann dabei jede der genannten Schichten, das heißt die Basisschicht 2, die Zwischenschicht 3 und / oder die Deckschicht 4 aus einer oder mehreren Schichten, Filmen und/oder Lagen bestehen.

Ein solches in Dünnschichttechnik hergestelltes Mehrschichtsystem ist in den unterschiedlichsten Industriezweigen im Rahmen der Oberflächenfunktionalisierung etabliert. Beispielsweise wird im Architektur- und Automobilbereich zu einem großen Teil Glas mit einer 50 - 150 Nanometer dicken Funktionsschicht versehen, die für Wärmedämmung oder Sonnenschutz sorgt. Diese Funktionsschicht besteht aus einem Schichtstapel unterschiedlichster Werksstoffe. Als kratzfeste Deckschicht kommt in vielen Schichtsystemen Siliziumnitrid zum Einsatz. Die Abscheidung dünner Schichten erfolgt hierbei in großem Umfang über das Magnetron-Sputtern, einem PVD-Verfahren (Physical Vapor Deposition). Für die optischen Eigenschaften sind Schichten aus Edelmetallen, beispielsweise Silber verantwortlich.

Figuren 2a - 2c zeigen spezielle Beispiele für Mehrschichtsysteme für verschiedene Anwendungen.

Figur 2a zeigt ein Beispiel für eine Wärmedämmschicht, eine sogenannte Single Low-E Schicht. Hierbei wird auf einem Substrat 20, im vorliegenden Fall Glas, zunächst eine Schicht aus Titandioxid 21, darüber eine Schicht Zinndioxid 22 und darüber eine Schicht Zinkoxid 23 aufgetragen. Anschließend wird eine Silberschicht 24 und eine Schutzschicht 25 aufgetragen. Über der Schutzschicht ist eine weitere Zinndioxidschicht 26 sowie als Deckschicht Siliziumnitrid 27 vorgesehen.

Figur 2b zeigt ein weiteres Beispiel für ein Mehrschichtsystem für Wärmedämmung in der Ausführung eines Double Low-E Mehrschichtsystems. Hierbei ist über dem Substrat 30 ebenfalls zunächst eine Schicht aus Titandioxid 31 vorgesehen. Die Deckschicht bildet wie in Figur 2a eine Schicht aus Siliziumnitrid 40. Die dazwischen liegenden Schichten sind jeweils zweimal vorgesehen. So ist über der Titandioxidschicht 31 eine Zinkoxidschicht 32, anschließend eine Silberschicht 33, darüber eine Schutzschicht 34 sowie anschließend eine Zinndioxidschicht 35 vorgesehen. Dieser Aufbau wird im Folgenden wiederholt, indem auf der Zinndioxidschicht 35 wieder eine Zinkoxidschicht 36, anschließend eine Silberschicht 37, darüber eine Schutzschicht 38 und als letzte Schicht unter der Deckschicht 40 eine Zinndioxidschicht 39 vorgesehen ist.

Figur 2c zeigt einen Schichtaufbau für eine Sonnenschutzschicht auf Glas. Hierbei ist auf dem Substrat 41, welches im vorliegenden Fall Glas ist, als Basisschicht Zinndioxid 42 aufgetragen, darüber als Zwischenschicht Chromnitrid 43 und als Deckschicht Siliziumnitrid 44.

Es sind aber auch andere Schichtaufbauten möglich. Insbesondere können silberbasierte Schichtsysteme wie in den eben genannten Beispielen mit einer oder mehrere elektrisch isolierenden oder teilweise elektrische isolierenden Deckschichten versehen sein. Beispiele für gebräuchliche Deckschichten sind Si₃N₄, aber auch Materialien wie SnZnOₓ, SnOₓ, BiOₓ, TiOₓ, SiOₓ, AIN oder andere Materialien.

Die Mehrschichtsysteme können auch auf der Gruppe der sogenannten TCOs (transparent conducting oxides) basieren. Anwendungen sind hierbei beispielsweise Mehrschichtsysteme für Flüssigkristallbildschirme, Leuchtdioden oder Touchscreens.

Die Idee der vorliegenden Erfindung ist es, die elektrisch leitfähigen Schichten innerhalb des Mehrschichtsystems elektrisch zu kontaktieren. Hierdurch wird eine Vielzahl unterschiedlicher Anwendungen ermöglicht. Beispielsweise wird durch eine Kontaktierung der elektrisch leitenden Schicht die flächige Widerstandsheizung von Glasscheiben ermöglicht. Eine weitere Anwendung ist eine Einbruchsicherung bei Glasscheiben in der Form einer Leiterschleife, so dass beispielsweise bei Zerstören der Glasscheibe und damit bei Zerstören der Leiterschleife ein Alarm ausgelöst wird. In einer weiteren Anwendung kann eine am Rand kontaktierte elektrisch leitfähige Schicht in einem Mehrschichtsystem als Teil einer Photovoltaik Anordnung dienen.

Die elektrisch leitfähige Schicht, welche kontaktiert werden soll, kann eine Silberschicht, eine Aluminiumschicht, eine NiV-Schicht, eine Molybdänschicht, eine Kupferschicht, eine andere metallische Schicht sein oder eine Kombination aus mehreren der genannten Materialien, sie kann auch aus einem Material aus der Gruppe der bereits genannten TCOs (transparent conducting oxides), wie z. B. SnO₂:F, ITO (Indiumzinnoxid), IZO (Indiumzinkoxid), ZnO:Al, ZnO:Sb oder ZnO:B bestehen. Auch für TCOs ist eine Kontaktierung möglich. Auch jedes Mehrschichtsystem mit einem oder mehreren der oben genannten elektrisch leitfähigen Materialien ist von der vorliegenden Erfindung mit umfasst.

Zum Kontaktieren tiefer liegender elektrisch leitfähiger Schichten in einem Mehrschichtsystem eignen sich übliche thermische Spritzverfahren nicht. Diese arbeiten mit Beschichtungsmaterialien, die im schmelzflüssigen Zustand auf das Substrat hin beschleunigt werden. Bei beschichtetem Glas ist dies mit einer unvertretbar hohen thermischen Belastung verbunden.

Bei der Kontaktierung von Solarzellen sind je nach Zelltyp verschiedene Verfahren etabliert: Bei Photovoltaikzellen auf Silizium-Waferbasis wird der solaraktive Schichtstapel häufig kontaktiert in einem Siebruckverfahren, indem eine Ag-Leitpaste mit anschließendem Einbrennvorgang mit Temperaturen zwischen 600°C und 1000°C aufgebracht wird. Auch hier ist die Beschichtung mit einer hoher thermischen Belastung verbunden.

Gemäß der vorliegenden Erfindung wird daher Kaltgasspritzen eingesetzt. Das erfindungsgemäße Verfahren erlaubt somit einen im Bezug auf die thermische Belastung des zuvor abgeschiedenen Schichtsystems deutlich schonenderen Prozess.

Das Kaltgasspritzen ist ein spezielles Verfahren des thermischen Spritzens. Hierbei werden Pulverpartikel in einem "kalten" Gasstrahl dergestalt beschleunigt, dass sie mit Überschall-Geschwindigkeit auf das Substrat treffen, um dort festhaftende Beschichtungen zu bilden. Das heißt die Beschichtung wird durch das Auftreffen der Partikel auf das Substrat mit hoher kinetischer Energie gebildet. Die Schmelztemperatur der Partikel wird dabei unter Standardbedingungen nicht erreicht. Beim Aufprall bilden die Partikel, die in dem kalten Gasstrahl nicht schmelzen, somit eine dichte und festhaftende Schicht, wobei plastische Verformung und daraus resultierende lokale Wärmefreigabe für Kohäsion und Haftung der Spritzschicht auf dem Substrat sorgen.

Die Vorteile des Kaltgasspritzens sind zum einen, wie bereits erwähnt, dass die Schmelztemperatur des Partikels nicht erreicht wird und die thermische Belastung des Mehrschichtsystems unbedenklich ist. Zum anderen zeichnet sich das Kaltgasspritzen durch geringe Porosität und einen geringen Sauerstoffgehalt aus. Dies führt insbesondere dazu, dass die elektrische und thermische Leitfähigkeit metallischer Schichten, welche mittels Kaltgasspritzen aufgebracht wurden, nahezu die Werte von kompakten Werkstoffen erreichen.

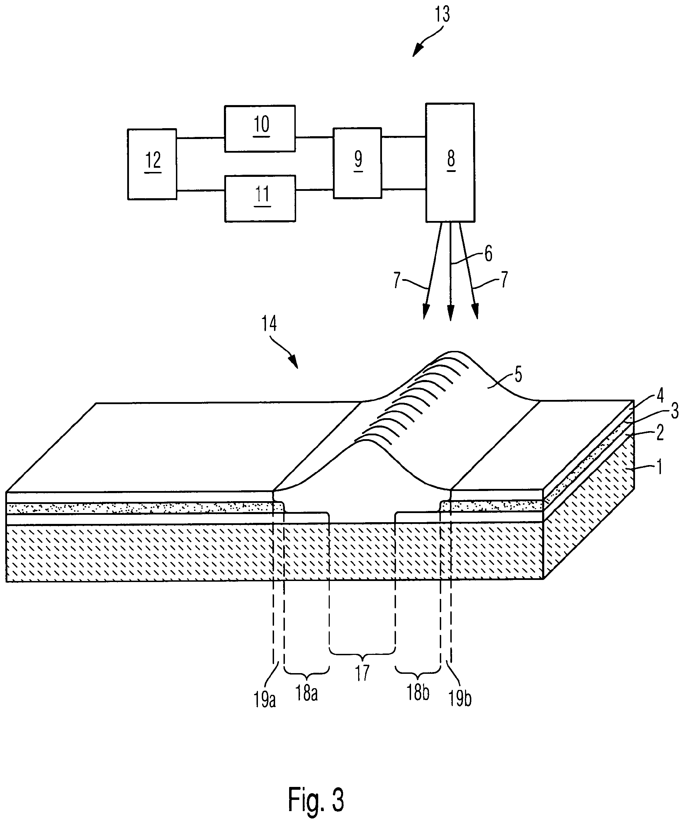

Eine Vorrichtung zum Kaltgasspritzen 13 ist in Figur 3 schematisch dargestellt. Eine Kontrolleinheit 12 überwacht hierbei die Abläufe und Funktionalitäten der einzelnen Komponenten. Die Kontrolleinheit 12 kann beispielsweise das An- und Abschalten der Vorrichtung zum Kaltgasspritzen 13 überwachen, einzelne Komponenten oder Ventile ansteuern. Das Trägergas ist in einer Gaskammer 11 unter Druck gespeichert. Die Spritzpartikel sind in einer Partikelkammer 10 gespeichert und werden über einen Drehförderer in eine Mischkammer 9 überführt. Nach Öffnen entsprechender Ventile durch die Kontrolleinheit 12 dringt Gas aus der Gaskammer 11 ebenfalls in die Mischkammer 9. Das Gas-Partikel-Gemisch wird anschließend über eine Düse 8 in Richtung des zu beschichtenden Substrats hin beschleunigt.

Ein Aufheizen des Gasstrahls erwärmt die Partikel zur besseren plastischen Verformung beim Aufprall und erhöht die Strömungsgeschwindigkeit des Gases und somit auch die Partikelgeschwindigkeit. Die hierbei verwendeten Gastemperaturen liegen deutlich unterhalb der Schmelztemperatur sowohl des zu beschichtenden Substrats als auch der Pulverpartikel. Die hohe kinetische Energie erhalten die Pulverpartikel bei der Gasentspannung. Nach der Injektion der Pulverpartikel in den Gasstrahl in der Mischammer 9 wird das Gas in einer Düse 8 entspannt, wobei Gas und Pulverpartikel auf Geschwindigkeiten über Schallgeschwindigkeit beschleunigt werden. Ein solches Verfahren und eine solche Vorrichtung zum Kaltgasspritzen sind in Detail in der Europäischen Patentschrift EP 0 484 533 B1 im Einzelnen beschrieben.

Die vorliegende Erfindung schlägt eine besondere Art des Kaltgasspritzens vor, bei welchem die einzelnen Parameter derart eingestellt wurden, dass es durch das Kaltgasspritzen ermöglicht wird, nicht nur eine haftende Schicht auf der obersten Schicht des Mehrschichtsystems oder allgemein auf der Oberfläche eines Substrats aufzubringen, sondern die Schichten des Mehrschichtsystems zu durchdringen und tiefer liegende Schichten zu kontaktieren. Der Begriff "Kontaktierung" im Sinne der vorliegenden Erfindung beschreibt hierbei eine Verbindung der unteren Schicht mit dem Kontaktelement derart, dass die Verbindung elektrisch leitfähig ist. Das Kontaktelement kann hierbei die untere Schicht nur oberflächlich berühren oder sie ganz oder teilweise durchdringen, von Bedeutung ist lediglich, dass die Verbindung eine elektrische Leitfähigkeit zwischen unterer Schicht und Kontaktelement herstellt.

Die Grundidee ist somit, ein Kontaktelement für ein Mehrschichtsystem vorzusehen. Hierbei sind auf einem Substrat zumindest eine obere und eine untere Schicht vorgesehen. Es können allerdings auch weitere Schichten vorgesehen sein. Insbesondere ist die untere Schicht entweder direkt auf dem Substrat angeordnet oder zwischen der unteren Schicht und dem Substrat sind eine oder weitere Schichten vorgesehen. Ebenso kann die obere Schicht direkt auf der unteren Schicht angeordnet sein oder es können eine oder mehrere Schichten zwischen der oberen und der unteren Schicht vorgesehen sein. Die vorliegende Erfindung schlägt ein Verfahren zum Kaltgasspritzen vor, so dass das mittels Kaltgasspritzen aufgebrachte Kontaktelement die obere Schicht durchdringt und die untere Schicht kontaktiert.

Dieses Prinzip ist ebenfalls in Figur 3 dargestellt. Figur 3 zeigt ein Substrat 1, welches im vorliegenden Beispiel Glas ist, eine darüber aufgebrachtes Basisschicht 2, eine darüber liegende Zwischenschicht 3, und eine über der Zwischenschicht aufgebrachte Deckschicht 4. Im vorliegenden Beispiel ist die Zwischenschicht 3 eine elektrisch leitfähige Schicht und kann metallisch sein und/oder auf TCOs basieren. Beispielsweise kann die Zwischenschicht 3 eine Silberschicht sein. Mittels Kaltgasspritzen wird ein Kontaktelement 5 so auf das System 14 aufgebracht, dass sie die Deckschicht 4, die Zwischenschicht 3 und die Basisschicht 2 durchdringt und haftend auf dem Substrat 1 aufgebracht ist. Die vorliegende Erfindung umfasst auch ein Kontaktelement 5, welches nur einen Teil der auf dem Substrat 1 aufgebrachten Schichten durchdringt und nicht bis auf das Substrat 1 hinunter dringt. Entscheidend ist vielmehr, dass die Durchdringtiefe bzw. Eindringtiefe des Kontaktelements 5 ausreichend ist, dass die leitende Schicht, im vorliegenden Beispiel Zwischenschicht 3 kontaktiert wird.

Die aus der Düse 8 austretenden Partikel haben dabei unterschiedliche Geschwindigkeiten. Die Partikelgeschwindigkeiten haben eine typische Verteilung, das heißt in der Mitte ist die Geschwindigkeit am größten. Dies entspricht einer solchen Eindringtiefe, dass eine feste Haftung auf dem Substrat 1 erreicht wird. Das gesamte auf dem Substrat 1 aufgetragene Schichtsystem wird in Folge der kinetischen Energie der Pulverpartikel durchschlagen. Am Rande des Spritzstrahls erreicht die Partikelgeschwindigkeit den Wert 0 und alle Partikel werden mit dem Gasstrom abgelenkt, es erfolgt somit keine Schichtbildung mehr. Im Übergangsbereich findet keine vollständige Durchdringung des Schichtsystems mehr statt, wodurch eine direkte Kontaktierung einzelner Zwischenschichten gelingt.

Dies wird im Folgenden anhand von Figur 3 nochmals im Detail erläutert. Der aus der Düse 8 austretende Partikelstrahl weist ein Kernzone 6 sowie Randzonen 7 auf. Die kinetische Energie der Partikel ist hierbei in der Kernzone 6 am höchsten und nimmt zu den Randzonen 7 hin ab. In Abhängigkeit der kinetischen Energie ändert sich auch die Durchdringtiefe der Partikel. Das aufgetragene Kontaktelement 5 weist somit einen Kernbereich 17 auf, bei welchem die kinetische Energie der Partikel in der Kernzone 6 groß genug ist, um alle Schichten des Schichtsystems zu durchdringen und bis auf das Substrat 1 hinunter zu dringen. In den Bereichen des Kontaktelements 5, welche durch Partikel aus den Randzonen 7 des Partikelstrahls aufgetragen wurden, verringert sich die Eindringtiefe. So ist in einer ersten Randzone 18a, 18b die Eindringtiefe der Partikel geringer und es erfolgt keine Haftung auf dem Substrat 1. Entsprechend ist weiter hin zur Randzone 7 die Eindringtiefe noch geringer so dass in einem zweiten Randbereich 19a, 19b lediglich die oberste Schicht, das heißt das Deckschichtsystem 4 durchdrungen wird. Noch weiter am Rand des Partikelstroms findet keine Haftung mehr statt.

In einer vorteilhaften Ausführungsform ist es möglich, eine Maskierung vorzusehen, die entweder den aus der Düse 8 austretenden Partikelstrom begrenzt oder die auf das Mehrschichtsystem aufgelegt werden kann, so dass die Breite des Kontaktelements 5 begrenzt ist.

Um ein Kontaktelement 5 gemäß der vorliegenden Erfindung auf einem Mehrschichtsystem auszubilden, ist eine besondere Einstellung der einzelnen Parameter der Vorrichtung zum Kaltgasspritzen 13 notwendig. Diese Parameter umfassen die Trägergastemperatur, den Trägergasdruck, die Überlaufgeschwindigkeit der Düse, das heißt die Relativgeschwindigkeit der Düse 8 zum Mehrschichtsystem 14, die Pulverförderrate bzw. die Drehzahl des Pulverförderers, der Abstand der Düse 8, bzw. des Düsenendes zur Oberfläche des Schichtsystems 14, die Pulverpartikelgrößenverteilung, das verwendete Trägergas sowie die verwendeten Partikel.

Durch eine besonders vorteilhafte Auswahl der Parameter, wird ein gewünschtes Kontaktelement 5 ausgebildet. Die optimalen Parameter sind hierbei die Verwendung von Aluminiumpartikeln mit einem Trägergas von Stickstoff N₂. Als Partikel können allerdings auch Kupfer, Silber, Zinn, Zink, Nickel, Titan oder Legierungen der genannten Materialien verwendet werden. Als Trägergase kommen wie bereits erläutert Stickstoff, aber auch Argon, Helium und Luft sowie Gemische hiervon in Frage.

Als Trägergastemperatur können Werte von 100°C bis 500°C verwendet werden, als optimal hat sich eine Trägergastemperatur von 400°C herausgestellt. Die Überlaufgeschwindigkeit der Düse ist beträgt 8 bis 12 Meter pro Minute und vorteilhafterweise 10 Meter pro Minute. Die Drehzahl des Pulverförderers beträgt 3 bis 5 Umdrehungen pro Minute und vorteilhafterweise vier Umdrehungen pro Minute, beziehungsweise beträgt die Pulverförderrate 5 bis 70 g/min, vorzugsweise 10 bis 20 g/min. Der optimale Abstand des Düsenendes der Düse 8 zur Oberfläche des Deckschichtsystems 4 sind 20 bis 30 mm und vorteilhafterweise 25mm.

Mögliche Werte für den Trägergasdruck bewegen sich im Bereich von 5 bis 30 bar, vorzugsweise 5 bis 25 bar. Als besonders vorteilhaft hat sich hierbei ein Wert von 15 bar erwiesen. Als Kriterium für ein geeignetes Kontaktelement 5 wurde hierbei der Widerstand des Kontaktelements sowie der Widerstand zwischen zwei Kontaktelementen verwendet. Gute Werte ergaben sich hierbei bei einem Druck von 15 bar, sowie ebenfalls bei einem Druck von 20 bar. Bei einem Druck von 25 bar steigt der Widerstand der Kontaktelemente deutlich an, weswegen ein Druck von 25 bar weniger geeignet ist.

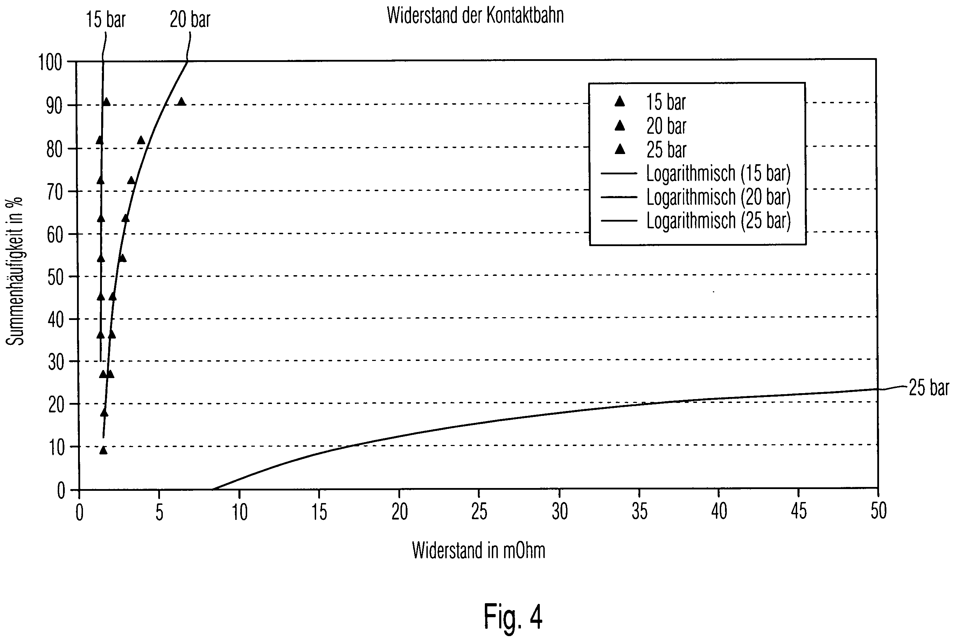

Figur 4 zeigt ein Diagramm bezüglich der Widerstände der Kontaktelemente. Hierbei wurden Aluminiumkontaktelemente auf ein Mehrschichtsystem 14 aufgebracht, so dass eine Silberschicht kontaktiert wurde. In dem Diagramm welches logarithmisch dargestellt ist, ist entlang der x-Achse der Widerstand in mOhm und entlang der y-Achse die Summenhäufigkeit in Prozent angegeben. Hierbei sind drei Kurven für drei unterschiedliche Werte des Trägergasdrucks dargestellt. Wie aus Figur 4 ersichtlich, ergeben sich gute Widerstandswerte für einen Trägergasdruck von 15 bar und 20 bar. Der Widerstand des Kontaktelements steigt hingegen bei einem Druck von 25 bar an.

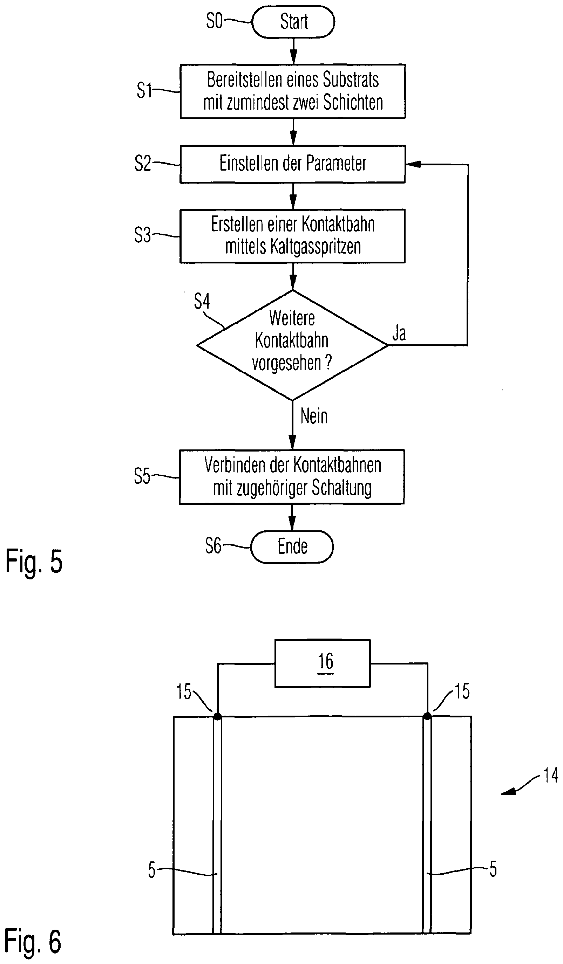

Figur 5 zeigt nochmals schematisch die Schritte zum Aufbringen eines Kontaktelements auf ein Mehrschichtsystem 14 gemäß des Verfahrens der vorliegenden Erfindung. Der Prozess startet in Schritt S0. Im nächsten Schritt S1 wird ein Substrat mit zumindest zwei Schichten bereitgestellt, das heißt ein Substrat auf dem eine obere und eine untere Schicht aufgebracht ist. Wie bereits erläutert ist hierbei lediglich die relative Anordnung der Schichten zueinander von Bedeutung, und es ist möglich keine, eine oder mehrere Schichten jeweils zwischen den genannten Schichten noch vorzusehen.

Im folgenden Schritt S2 werden die Parameter für die Vorrichtung zum Kaltgasspritzen 13 eingestellt. Im folgenden Schritt S3 wird ein Kontaktelement 5 mittels Kaltgasspritzen erstellt. Nach Erstellen des Kontaktelements 5 wird in einem nächsten Schritt S4 überprüft, ob weitere Kontaktelemente vorgesehen sind. Falls dies nicht der Fall ist, können in einem nächsten Schritt S5 die erstellten Kontaktelemente 5 mit einer zugehörigen Schaltung je nach gewünschter Anwendung verbunden werden.

Andernfalls, falls in Schritt S4 festgestellt wird, das weitere Kontaktelemente vorgesehen sind, so geht der Prozess zurück zu Schritt S2, wo erneut die Parameter eingestellt werden, um ein weiteres Kontaktelement aufzubringen. Der Prozess endet in Schritt S6.

Figur 6 zeigt schematisch eine Draufsicht auf ein System 14 auf dem zwei Kontaktelemente 5 aufgebracht sind.

Vorteilhafterweise werden die Kontaktelemente 5 als schmale Streifen bzw. Bahnen auf das System 14 aufgebracht. Allerdings ist auch eine flächigere oder anders angeordnete Aufbringung von Kontaktelementen 5 möglich. Insbesondere ist auch eine punkt- oder kreisförmige Form des Kontaktelements 5 möglich. In einer weiteren Ausführungsform kann das Kontaktelement 5 das Mehrschichtsystem 14 vollständig bedecken, so dass das Kontaktelement 5 zugleich eine Deckschicht des Mehrschichtsystems 14 darstellt. Wenn mehrere Kontaktelemente 5 vorgesehen sind, können die einzelnen Elemente auch unterschiedliche Formen aufweisen. Des Weiteren ist die vorliegende Erfindung nicht auf das Vorsehen von zwei Kontaktelementen 5 beschränkt.

Wie in Figur 6 exemplarisch dargestellt, wurden zwei Kontaktelementstreifen auf das System 14 aufgebracht. Diese Kontaktelemente 5 können über Kontaktpunkte 15 kontaktiert werden, so dass eine entsprechende Schaltung 16 an die Kontaktelemente 5 angeschlossen werden kann. Wie Eingangs bereits erläutert, kann diese Schaltung 16 unterschiedliche Anwendungen ermöglichen.

Beispielsweise kann durch die Schaltung 16 ein flächiges Heizen einer Glasscheibe erfolgen. Die vorliegende Erfindung kann in verschiedenen Bereichen bei der Kontaktierung von flächigen Glasanwendungen eingesetzt werden, beispielsweise bei Leuchtschichten, Folien oder ähnlichen Schichtsystemen. Des weiteren kann eine Einbruchssicherung vorgesehen sein oder das System 14 mit den Kontaktelementen 5 kann als Teil einer Photovoltaik Zelle vorgesehen sein, wie im folgenden genauer erläutert wird.

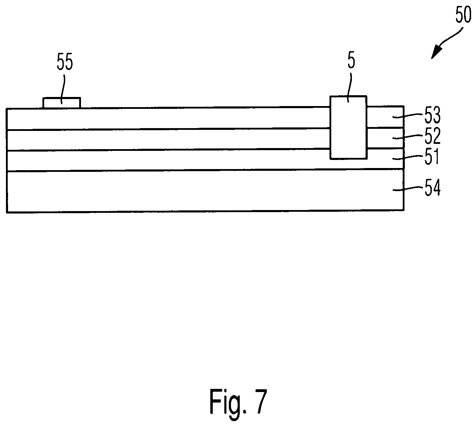

Bei photovoltaischen Zellen wird in der Regel eine solaraktive Schicht zwischen zwei Kontaktschichten aufgebracht. Der vereinfachte Aufbau einer photovoltaischen Zelle 50 wird nun bezugnehmend auf Figur 7 genauer erläutert.

Auf einem Substrat 54 oder einem Superstrat 54 ist eine erste Kontaktschicht 51 und eine zweite Kontaktschicht 53 vorgesehen mit einer zwischen den Kontaktschichten 51, 53 angeordneten solaraktiven Schicht 52. Darüber hinaus können weitere Zwischenschichten und/oder eine Deckschicht vorgesehen sein und die aufgeführten Schichten können jeweils aus mehreren Teilschichten bestehen.

Gemäß der vorliegenden Erfindung wird auf das Schichtsystem ein Kontaktelement 5 aufgebracht, welches zumindest die solaraktive Schicht 52 durchdringt und die tiefer liegende Kontaktschicht, welche im vorliegenden Beispiel die erste Kontaktschicht 51 ist, kontaktiert. Im Falle, dass die zweite Kontaktschicht 53 gleichzeitig die Deckschicht ist, kann ein Kontaktpunkt 55 mit herkömmlichen Verfahren aufgebracht werden. Andernfalls, falls über der zweiten Kontaktschicht 53 noch eine Deckschicht angeordnet ist, kann auch die zweite Kontaktschicht 53 mittels eines erfindungsgemäßen Kontaktelements kontaktiert werden. Je nachdem ob die photovoltaische Zelle 50 mit einem Substrat oder einem Superstrat vorgesehen ist, wird die mittels des Kontaktelements 5 erste Kontaktschicht 51 kontaktiert und die zweite Kontaktschicht 53 durchdrungen oder umgekehrt. In jedem Fall durchdringt das Kontaktelement jedoch die solaraktive Schicht 52 und kontaktiert zumindest eine tiefer liegende Kontaktschicht.

Bei Verwendung eines Superstrats 54 erfolgt die Orientierung mit dem Superstrat 54 zur Lichtquelle bzw. Sonne hin, beim Aufbau als Substrat 54 erfolgt die Orientierung des Substrats 54 von der Lichtquelle bzw. Sonne weg.

Beispiele für das Material der solaraktiven Schicht 52 sind z.B. amorphes Silizium, mikromorphes Silizium, Tandemzellen auf Basis von amorphem Silizium, CdTe, sogenannte CIS-Zellen auf Basis von Kupfer, Indium, Gallium, Selen und / oder Schwefel, oder andere Materialien, welche solaraktive Eigenschaften besitzen.

Zur Kontaktierung und Ableitung des erzeugten elektrischen Stromes werden die erste Kontaktschicht 51 und die zweite Kontaktschicht 53 üblicherweise mit elektrisch leitfähigen Kabeln verbunden. Die Kontaktierung erfolgt üblicherweise durch Löten, was gerade auf den Dünnschichtzellen und den verwendeten Materialien problembehaftet sein kann.
Die Kontaktierung der tiefer liegenden ersten Kontaktschicht 51 erfolgt nach den bekannten Verfahren häufig über zuvor direkt auf das Substrat bzw. Superstrat aufgebrachte Kontaktstreifen, die dann überbeschichtet werden.

Gemäß der vorliegenden Erfindung wird dagegen die nachträgliche Kontaktierung der unteren ersten Kontaktschicht 51 und im Falle, dass über der zweiten Kontaktschicht 53 noch eine Deckschicht vorgesehen ist, auch die nachträgliche elektrische Kontaktierung der zweiten Kontaktschicht 53 ermöglicht. Anschließend kann die Verbindung zu dem elektrischen Kabel durch Anlöten an das erfindungsgemäße Kontaktelement 5 erfolgen. Die vorliegende Erfindung kann insbesondere im Randbereich von Dünnschichtzellen vorteilhaft angewendet werden. Hierdurch wird die Herstellung photovoltaischer Zellen vereinfacht und ein Schaden beispielsweise durch thermische Belastung bei der elektrischen Kontaktierung der Kontaktschichten 51, 53 wird vermieden.

Die vorliegende Erfindung stellt somit ein Mehrschichtsystem mit einem Kontaktelement 5 bereit, bei welchem eine elektrische Kontaktierung von Zwischenschichten innerhalb des Systems 14 ermöglicht wird. Des Weiteren offenbart die vorliegende Erfindung ein Verfahren zum Erstellen eines Kontaktelements für ein Mehrschichtsystem, welches die Kontaktierung tiefer liegender Schichten auch nach Erstellen des Mehrschichtsystems 14 ermöglicht. Dadurch, dass das Kontaktelement 5 auch an der Oberfläche des Mehrschichtsystems 14 vorgesehen ist, ermöglicht dies eine leichte Kontaktierung bzw. einen leichten Anschluss des Kontaktelements 5 an weitere Komponenten und/oder Schaltungen.

Die vorliegende Erfindung ist anwendbar auf jede Art von Mehrschichtsystemen mit zumindest einer elektrisch leitfähigen Schicht. Die elektrisch leitfähige Schicht kann metallisch oder auf transparent leitfähigen Oxiden, sog. TCOs (transparent conducting oxide) basierend sein. Im Falle mehrerer elektrisch leitfähiger Schichten innerhalb eines Mehrschichtsystems können die elektrisch leitfähigen Schichten entweder metallisch und/oder auf TCOs basierend sein. Die vorliegende Erfindung betrifft insbesondere Mehrschichtsysteme im Bereich der Dünnschichttechnik, der Displaytechnik, der Automobiltechnik oder der Beleuchtungstechnik. Anwendungen sind beispielsweise Verglasungen, Solarzellen, Displays oder dergleichen.

Die Erfindung ist nicht auf die dargestellten Ausführungsbeispiele beschränkt.

## Patentansprüche

1. Schichtsystem mit Kontaktelement (5) umfassend ein Substrat (1),
ein auf dem Substrat (1) angeordnetes Mehrschichtsystem (14) mit zumindest einer oberen (3; 4) und einer unteren (2; 3) Schicht,
**dadurch gekennzeichnet,**
**dass** ein Kontaktelement (5), mittels Kaltgasspritzen aufgebracht ist und die zumindest eine obere Schicht (3; 4) durchdringt und die untere Schicht (2; 3) kontaktiert.

2. Schichtsystem mit Kontaktelement (5) nach Anspruch 1,
**dadurch gekennzeichnet,**
**dass** das Kontaktelement (5) aus elektrisch leitfähigem Material, vorzugsweise aus Aluminium, Kupfer, Silber, Zinn, Zink, Nickel, Titan oder einer Legierung der genannten Materialien ist.

3. Schichtsystem mit Kontaktelement (5) nach Anspruch 1 oder 2,
**dadurch gekennzeichnet,**
**dass** das Substrat (1) Glas ist.

4. Schichtsystem mit Kontaktelement (5) nach Anspruch 1, 2 oder 3,
**dadurch gekennzeichnet,**
**dass** die untere Schicht (2; 3) eine elektrisch leitende Schicht ist.

5. Schichtsystem mit Kontaktlemen (5) nach Anspruch 4,
**dadurch gekennzeichnet,**
**dass** die untere Schicht (2; 3) vorzugsweise eine Aluminiumschicht, eine NiV-Schicht, eine Molybdänschicht, eine Kupferschicht, eine Edelmetall-Schicht oder eine Kombination aus den genannten Materialen, besonders bevorzugt eine Silberschicht ist.

6. Schichtsystem nach Anspruch 4,
**dadurch gekennzeichnet,**
**dass** die untere Schicht (2; 3) aus einem Material aus der Gruppe der transparent leitfähigen Oxide, bevorzugt aus SnO₂:F, Indiumzinnoxid ITO, Indiumzinkoxid IZO, ZnO:Al, ZnO:Sb oder ZnO:B besteht.

7. Schichtsystem mit Kontaktelement (5) nach einem der Ansprüche 1 bis 6,
**dadurch gekennzeichnet,**
**dass** das Kontaktelement (5) das Mehrschichtsystem (14) zumindest teilweise bedeckt.

8. Schichtsystem mit Kontaktelement (5) nach Anspruch 7,
**dadurch gekennzeichnet,**
**dass** das Kontaktelement (5) als Streifen auf dem Mehrschichtsystem (14) ausgebildet ist.

9. Schichtsystem mit Kontaktelement (5) nach einem der Ansprüche 1 bis 8,
**dadurch gekennzeichnet,**
**dass** zwei Kontaktelemente (5) auf dem Mehrschichtsystem (14) ausgebildet sind.

10. Schichtsystem mit Kontaktelement (5) nach einem der vorhergehenden Ansprüche,
**dadurch gekennzeichnet,**
**dass** das Mehrschichtsystem (14) eine photovoltaische Zelle (50), vorzugsweise eine photovoltaische Dünnschichtzelle ist.

11. Schichtsystem mit Kontaktelement (5) nach Anspruch 10,
**dadurch gekennzeichnet,**
**dass** die photovoltaische Zelle (50) zumindest zwei Kontaktschichten (51, 53) und eine zwischen den Kontaktschichten (51, 53) angeordnete solaraktive Schicht (52) umfasst und
**dass** das Kontaktelement (5) zumindest die solaraktive Schicht durchdringt und zumindest eine der Kontaktschichten (51, 53) kontaktiert.

12. Verfahren zum Erstellen eines Kontaktelements (5) für ein Schichtsystem umfassend die Schritte
- Bereitstellen eines Substrats (1) mit einem auf dem Substrat (1) angeordneten Mehrschichtsystem (14) mit zumindest einer oberen (3; 4) und einer unteren (2; 3) Schicht und
- Aufbringen eines Kontaktelements (5) mittels Kaltgasspritzen derart, dass das Kontaktelement (5) die zumindest eine obere Schicht (3; 4) durchdringt und die untere Schicht (2; 3) kontaktiert.

13. Verfahren nach Anspruch 12,
**gekennzeichnet durch**
das Vorsehen einer Vorrichtung zum Kaltgasspritzen (13) umfassend eine Trägergaskammer (11), eine Partikelkammer (10), einen Pulverförderer zum Verbringen der Partikel aus der Partikelkammer (10) in eine Mischkammer (9) und eine Düse (8) zum Aufbringen des Partikel-Gas-Gemisches aus der Mischkammer (9) auf das Mehrschichtsystem (14).

14. Verfahren nach Anspruch 13,
**gekennzeichnet durch**
das Vorsehen von Stickstoff N₂ als Trägergas.

15. Verfahren nach Anspruch 13 oder 14,
**gekennzeichnet durch**
das Vorsehen von Aluminiumpartikeln als Pulver.

16. Verfahren nach einem der Ansprüche 13 bis 15,
**gekennzeichnet durch**
das Vorsehen einer Trägergastemperatur von 100°C bis 500°C, vorzugsweise von 400°C.

17. Verfahren nach einem der Ansprüche 13 bis 16,
**gekennzeichnet durch**
das Vorsehen eines Trägergasdrucks von 5 bar bis 30 bar, vorzugsweise von 5 bar bis 25 bar, besonders bevorzugt von 15 bar.

18. Verfahren nach einem der Ansprüche 13 bis 17,
**gekennzeichnet durch**
das Vorsehen einer Relativgeschwindigkeit der Düse (8) der Vorrichtung zum Kaltgasspritzen (13) gegenüber dem Substrat (1) mit dem Mehrschichtsystem (14) von 10 m/min.

19. Verfahren nach einem der Ansprüche 13 bis 18,
**gekennzeichnet durch**
das Vorsehen einer Pulverförderrate der Vorrichtung zum Kaltgasspritzen (13) von 5 bis 70 g/min, bevorzugt von 10 bis 20 g/min.

20. Verfahren nach einem der Ansprüche 13 bis 19,
**gekennzeichnet durch**
das Vorsehen eines Abstands zwischen der Düse (8) der Vorrichtung zum Kaltgasspritzen (13) und dem Mehrschichtsystem (14) von 20mm bis 30mm, vorzugsweise von 25 mm.

## Claims

1. Layer system having a contact element (5) comprising a substrate (1),
a multi-layer system (14) which is arranged on the substrate (1) and which has at least an upper layer (3; 4) and a lower layer (2; 3),
**characterised in that**
a contact element (5) is applied by means of gas dynamic cold spray and extends through the at least one upper layer (3; 4) and contacts the lower layer (2; 3).

2. Layer system having a contact element (5) according to claim 1,
**characterised in that**
the contact element (5) is produced from electrically conductive material, preferably from aluminium, copper, silver, tin, zinc, nickel, titanium or an alloy of the materials mentioned.

3. Layer system having a contact element (5) according to claim 1 or 2,
**characterised in that**
the substrate (1) is glass.

4. Layer system having a contact element (5) according to claim 1, 2 or 3,
**characterised in that**
the lower layer (2; 3) is an electrically conductive layer.

5. Layer system having a contact element (5) according to claim 4,
**characterised in that**
the lower layer (2; 3) is preferably an aluminium layer, an NiV layer, a molybdenum layer, a copper layer, a precious metal layer or a combination of the materials mentioned, particularly preferably a silver layer.

6. Layer system according to claim 4,
**characterised in that**
the lower layer (2; 3) consists of a material from the group including transparent conductive oxides, preferably SnO₂:F, indium tin oxide ITO, indium zinc oxide IZO, ZnO:AI, ZnO:Sb or ZnO:B.

7. Layer system having a contact element (5) according to any one of claims 1 to 6,
**characterised in that**
the contact element (5) at least partially covers the multi-layer system (14).

8. Layer system having a contact element (5) according to claim 7,
**characterised in that**
the contact element (5) is constructed as strips on the multi-layer system (14).

9. Layer system having a contact element (5) according to any one of claims 1 to 8,
**characterised in that**
two contact elements (5) are formed on the multi-layer system (14).

10. Layer system having a contact element (5) according to any one of the preceding claims,
**characterised in that**
the multi-layer system (14) is a photovoltaic cell (50), preferably a photovoltaic thin layer cell.

11. Layer system having a contact element (5) according to claim 10,
**characterised in that**
the photovoltaic cell (50) comprises at least two contact layers (51, 53) and a solar-active layer (52) which is arranged between the contact layers (51, 53), and
**in that** the contact element (5) extends through at least the solar-active layer and contacts at least one of the contact layers (51, 53).

12. Method for producing a contact element (5) for a layer system comprising the steps of
- providing a substrate (1) having a multi-layer system (14) which is arranged on the substrate (1) and which has at least an upper layer (3; 4) and a lower layer (2; 3), and
- applying a contact element (5) by means of gas dynamic cold spray in such a manner that the contact element (5) extends through the at least one upper layer (3; 4) and contacts the lower layer (2; 3).

13. Method according to claim 12,
**characterised by**
the provision of a device for gas dynamic cold spray (13) comprising a carrier gas chamber (11), a particle chamber (10), a powder conveyor for conveying the particles from the particle chamber (10) into a mixing chamber (9) and a nozzle (8) for applying the particle/gas admixture from the mixing chamber (9) to the multi-layer system (14).

14. Method according to claim 13,
**characterised by**
the provision of nitrogen N₂ as a carrier gas.

15. Method according to claim 13 or 14,
**characterised by**
the provision of aluminium particles as a powder.

16. Method according to any one of claims 13 to 15,
**characterised by**
the provision of a carrier gas temperature of from 100°C to 500°C, preferably of 400°C.

17. Method according to any one of claims 13 to 16,
**characterised by**
the provision of a carrier gas pressure of from 5 bar to 30 bar, preferably of from 5 bar to 25 bar, particularly preferably 15 bar.

18. Method according to any one of claims 13 to 17,
**characterised by**
the provision of a relative speed of the nozzle (8) of the device for gas dynamic cold spray (13) with respect to the substrate (1) with the multi-layer system (14) of 10 m/min.

19. Method according to any one of claims 13 to 18,
**characterised by**
the provision of a powder conveying rate of the device for gas dynamic cold spray (13) of from 5 to 70 g/min, preferably of from 10 to 20 g/min.

20. Method according to any one of claims 13 to 19,
**characterised by**
the provision of a spacing between the nozzle (8) of the device for gas dynamic cold spray (13) and the multi-layer system (14) of from 20 mm to 30 mm, preferably of 25 mm.

## Revendications

1. Système de couches avec élément de contact (5) comprenant
un substrat (1),
un système multicouche (14) disposé sur le substrat (1) avec au moins une couche supérieure (3 ; 4) et une couche inférieure (2 ; 3),
**caractérisé en ce**
**qu'**un élément de contact (5) est appliqué par projection de gaz à froid et pénètre l'au moins une couche supérieure (3 ; 4) et est en contact avec la couche inférieure (2 ; 3).

2. Système de couches avec élément de contact (5) selon la revendication 1,
**caractérisé en ce**
**que** l'élément de contact (5) est en matériau électriquement conducteur, de préférence en aluminium, en cuivre, en argent, en étain, en zinc, en nickel, en titane ou en un alliage des matériaux susmentionnés.

3. Système de couches avec élément de contact (5) selon la revendication 1 ou 2,
**caractérisé en ce**
**que** le substrat (1) est du verre.

4. Système de couches avec élément de contact (5) selon la revendication 1, 2 ou 3,
**caractérisé en ce**
**que** la couche inférieure (2 ; 3) est une couche électriquement conductrice.

5. Système de couches avec élément de contact (5) selon la revendication 4,
**caractérisé en ce**
**que** la couche inférieure (2 ; 3) est de préférence une couche d'aluminium, une couche de NiV, une couche de molybdène, une couche de cuivre, une couche de métal noble ou une combinaison des matériaux mentionnés, de manière particulièrement préférée une couche d'argent.

6. Système de couches selon la revendication 4,
**caractérisé en ce**
**que** la couche inférieure (2 ; 3) se compose d'un matériau issu du groupe des oxydes conducteurs transparents, de préférence de SnO₂:F, d'oxyde d'indium-étain ITO, d'oxyde d'indium-zinc IZO, de ZnO:Al, de ZnO:Sb ou de ZnO:B.

7. Système de couches avec élément de contact (5) selon l'une des revendications 1 à 6,
**caractérisé en ce que**
l'élément de contact (5) recouvre au moins en partie le système multicouche (14).

8. Système de couches avec élément de contact (5) selon la revendication 7,
**caractérisé en ce**
**que** l'élément de contact (5) est formé comme une bande sur le système multicouche (14).

9. Système de couches avec élément de contact (5) selon l'une des revendications 1 à 8,
**caractérisé en ce**
**que** deux éléments de contact (5) sont formés sur le système multicouche (14).

10. Système de couches avec élément de contact (5) selon l'une des revendications précédentes,
**caractérisé en ce**
**que** le système multicouche (14) est une cellule photovoltaïque (50), de préférence une cellule photovoltaïque à couche mince.

11. Système de couches avec élément de contact (5) selon la revendication 10,
**caractérisé en ce**
**que** la cellule photovoltaïque (50) comprend au moins deux couches de contact (51, 53) et une couche solaire active (52) disposée entre les couches de contact (51, 53) et
en ce que l'élément de contact (5) pénètre au moins la couche solaire active et est en contact avec au moins une des couches de contact (51, 53).

12. Procédé de fabrication d'un élément de contact (5) pour un système de couches, comprenant les étapes de
- fourniture d'un substrat (1) avec un système multicouche (14) disposé sur le substrat (1) avec au moins une couche supérieure (3 ; 4) et une couche inférieure (2 ; 3) et
- application d'un élément de contact (5) par projection de gaz à froid de telle sorte que l'élément de contact (5) pénètre l'au moins une couche supérieure (3 ; 4) et est en contact avec la couche inférieure (2 ; 3) .

13. Procédé selon la revendication 12,
**caractérisé par**
la prévision d'un dispositif de projection de gaz à froid (13) comprenant une chambre de gaz porteur (11), une chambre à particules (10), un dispositif d'acheminement de poudre pour le transfert des particules provenant de la chambre à particules (10) dans une chambre de mélange (9) et une buse (8) pour l'application du mélange gaz-particules provenant de la chambre de mélange (9) sur le système multicouche (14).

14. Procédé selon la revendication 13,
**caractérisé par**
la prévision d'azote N₂ comme gaz porteur.

15. Procédé selon la revendication 13 ou 14,
**caractérisé par**
la prévision de particules d'aluminium comme poudre.

16. Procédé selon l'une des revendications 13 à 15,
**caractérisé par**
la prévision d'une température de gaz porteur de 100 °C à 500 °C, de préférence de 400 °C.

17. Procédé selon l'une des revendications 13 à 16,
**caractérisé par**
la prévision d'une pression de gaz porteur de 5 bar à 30 bar, de préférence de 5 bar à 25 bar, de manière particulièrement préférée de 15 bar.

18. Procédé selon l'une des revendications 13 à 17,
**caractérisé par**
la prévision d'une vitesse relative de la buse (8) du dispositif de projection de gaz à froid (13) par rapport au substrat (1) avec le système multicouche (14) de 10 m/min.

19. Procédé selon l'une des revendications 13 à 18,
**caractérisé par**
la prévision d'un débit d'acheminement de poudre du dispositif de projection de gaz à froid (13) de 5 à 70 g/min, de préférence de 10 à 20 g/min.

20. Procédé selon l'une des revendications 13 à 19,
**caractérisé par**
la prévision d'un espace entre la buse (8) du dispositif de projection de gaz à froid (13) et le système multicouche (14) de 20 mm à 30 mm, de préférence de 25 mm.
